# EUROPÄISCHE PATENTANMELDUNG

(11) **EP 1 191 605 A2**
(43) Veröffentlichungstag der Anmeldung: **27.03.2002**
(21) Anmeldenummer: 01250338.9
(22) Anmeldetag: 26.09.2001
(51) Int. Cl.: H01L 31/048, E04D 13/18

(54) **Glasloses, flexibles Solar-Laminat**

(30) Priorität: 26.09.2000 DE 10048034
(71) Anmelder: Zenit Energietechnik GmbH, 12459 Berlin (DE)
(72) Erfinder: Kalberlah, Klaus, 12459 Berlin (DE)
(74) Vertreter: Goesch, Wilfried H.

(57) **Zusammenfassung**

Derartige Solar-Laminate werden für die Gebäudetechnik verwendet, ausschließlich nach werksseitiger Verklebung unter Druck und Temperatur (ca.130°C) auf Stahlblech (Dachscharen). Es soll eine andersgeartete Vor-Ort-Befestigung angegeben werden.

Hierfür wird das Solar-Laminat zur Vor-Ort-Befestigung auf ebenen Gebäude-Außenflächen wie Dach oder Fassade auf seiner Rückseite mit einer Selbstklebeschicht versehen, in die flache elektrische Leitungen (5) zum elektrischen Anschluss auf der Dach/Fassadenaußenseite und zusätzlich Leitungen (6) für die Durchgangsverdrahtung eingebettet sind.

## Beschreibung

Die Erfindung betrifft ein glasloses, flexibles Solar-Laminat zur Umwandlung von Tageslicht in elektrische Energie, hergestellt nach einer Dünnschicht-Technologie durch Abscheiden auf einem flexiblen Substrat.

Solar-Laminate, d.h. rahmenlose Einbettungen von kristallinen Solarzellen zwischen Glas oder lichtdurchlässige Kunststoffschichten, werden seit Jahren von zahlreichen Firmen hergestellt und geliefert. Soweit sie glaslos und somit wenigstens geringfügig flexibel sind, finden derartige Solar-Laminate beispielsweise zur Verklebung mit doppelseitigem Klebeband auf Bootsdecks oder auf der Oberseite von Caravan-Wohnwagen Verwendung. Eine derartige Verklebung von Solar-Laminaten mit Dach- oder Fassadenflächen ist aber bisher aus verschiedenen, beispielsweise nachgenannten Gründen unterblieben:
1. Während Solar-Laminate für Boote und Caravans eine Gewährleistung von max. 5 Jahren aufweisen, wird von gebäude-integrierten Solarmodulen eine Leistungsgarantie von 20 Jahren verlangt. Eine Gewährleistung kann für derartig lange Zeiträume für bekannte Verklebungen jedoch bisher nicht übernommen werden, insbesondere weil sich die bekannten Klebstoffe für die Verklebung des Trägermaterials der Solar-Laminate als ungeeignet oder nicht dauerhaft genug erwiesen haben.
2. Die üblicherweise genutzten Boots- und Caravanflächen sind wenig oder gar nicht geneigt; die Beanspruchung der Verklebung durch Scherkräfte ist demnach ungleich geringer als bei stark geneigten Dach- oder bei Fassadenflächen.
3. Es werden nur wenige, quasi einzelne Solar-Laminate auf Booten oder Caravans aufgeklebt und deren Anschlusskabel offen verlegt, während auf einer Dachfläche eine Vielzahl von Laminaten flächendeckend eingesetzt wird, wobei die Verkabelung einerseits nicht äußerlich sichtbar sein soll. Andererseits darf aber die Dachhaut auch nicht pro Solar-Laminat ein- oder zweimal (Plus- und Minusanschluss) durchbrochen werden.
4. Die für Dächer verwendeten Materialien, beispielsweise Zinkblech, sind wesentlich unterschieden von den Materialien auf Booten und Caravans, meist Holz oder Kunststoff. Somit spielt, bei den bisher praktizierten Verklebungen, das Problem der Erwärmung des Untergrundes sowie das Problem eines vom Solar-Laminat stark abweichenden Ausdehnungskoeffizienten keine Rolle.
5. Bisher vorgenommene Verklebungen (z.B. mit Selbstklebe - Band) waren in den wenigsten Fällen vollflächig. Die Rückseite des Laminates war somit wenigstens teilsweise Klimaeinflüssen, wie beispielsweise Luftfeuchtigkeit ungeschützt ausgesetzt. Dies spielt bei den für Boote und Caravans praktisch ausschließlich genutzten Solar-Laminaten mit kristallinem Zellenaufbau keine Rolle, ist jedoch bei den für die Gebäudeintegration bestimmten Laminaten mit empfindlichem Dünnschicht-Zellenaufbau durchaus ein Problem.

Laminate, d.h. nicht-kristalline, flexible Solarzellen aus Dünnschicht-Silizium, aufgedampft auf Edelstahl, sind ebenfalls seit Jahren im Handel. Derartige Laminate werden für die Gebäudetechnik sehr wohl verwendet, jedoch ausschließlich nach werksseitiger Verklebung unter Druck und Temperatur (ca.130°C) auf Stahlblech (Dachscharen). Die vom Laminathersteller zwingend vorgeschriebene EVA-Schmelzklebefolie ist ein Duromer, d.h. es entseht durch den "bonding"-Prozeß auf dem Heiztisch eine unelastische Verbindung zwischen dem an sich flexiblen Laminat und dem Dachblech. Als Material für die Dachscharen kann daher nur Stahlblech Verwendung finden; ein unterschiedlicher Ausdehnungskoeffizient könnte bei der üblichen Temperaturbeanspruchung von Dächern mit dunkler Oberfläche (minus 20 bis plus 85°C) zur Beschädigung des starr verbundenen Laminats führen, beispielsweise durch die Bildung von Mikrorissen. Diese müssen, weil die Dünnschichtzellen im Inneren des Laminats durch eindringende Luftfeuchtigkeit geschädigt würden, unbedingt vermieden werden.

Auch bei stark gewölbten Dachflächen entstehen Probleme, weil sich die solar beschichteten Dachscharen nur noch schwer weiterverarbeiten (wölben) lassen.

Bei einem in jüngster Zeit unter der Bezeichnung "peel and stick" auf den Markt gekommenen Solar-Laminat wird als Klebeschicht eine dünne, rückseitig auf das Laminat aufgetragene Bitumenschicht verwendet. Erwiesenermaßen hält diese jedoch der Temperaturbeanspruchung der für Solarmodule relevanten IEC-Norm 61646 nicht stand und ist zudem lt. Herstellerangabe ausdrücklich nur für die Verwendung auf Stahlblech vorgesehen.

Ein weiteres Problem von Solar-Laminaten besteht darin, dass diese Strom erzeugen, sobald sie dem Tageslicht ausgesetzt sind. Ihre Montage erfordert also, ebenso wie die normaler Solarmodule, zumindest bei der üblichen Reihenschaltung mehrerer Laminate auf höhere Spannungen entsprechend den gültigen Vorschriften eine Lizenz als Elektrofachbetrieb bzw. entsprechende Fachkenntnisse. In Publikationen wird deshalb empfohlen, die Module während der Montage mit Decken gegen die Tageshelligkeit abzuschirmen und so an der Erzeugung potentiell gefährlicher Spannungen und Ströme zu hindern.

Außerdem besteht bei flexiblen, verklebten Laminaten wie oben unter Punkt 3. bereits erwähnt ein Problem hinsichtlich der Verschaltung der einzelnen Laminate.

Die Erfindung hat es sich zur Aufgabe gemacht, ein glas- und rahmenloses Solar-Laminat vorzuschlagen, das sich auf einfache Weise dauerhaft vor Ort auf einer Dach- oder Fassadenfläche befestigen und elektrisch verschalten lässt. Die Erfindung hat sich zugleich auch noch das Ziel gesetzt, die Stromerzeugung bis zur Fertigstellung des Daches und Eintreffen eines Elektrikers praktikabel zu unterbinden.

Die Aufgabe wird erfindungsgemäß gelöst durch die Merkmale im kennzeichnenden Teil des Anspruchs 1 im Zusammenwirken mit den Merkmalen im Oberbegriff. Zweckmäßige Ausgestaltungen der Erfindung sind Gegenstand der Unteransprüche.

Danach ist das Solar-Laminat zur Vor-Ort-Befestigung auf ebenen Gebäude-Außenflächen wie Dach oder Fassade auf seiner Rückseite mit einer dauerelastischen Selbstklebeschicht versehen, in die flache elektrische Leitungen zum elektrischen Anschluss auf der First- und Traufseite des Daches bzw. den Fassadenaußenseiten und zusätzlich Leitungen für die Durchgangsverdrahtung eingebettet sind.

In erfindungsgemäßer Ausgestaltung besteht die Selbstklebeschicht aus mindestens zwei, sich in ihrer Wirkweise hinsichtlich Anfangsklebkraft und Dauerklebkraft ergänzenden Klebstoffsystemen.

In bevorzugter Weise bestehen die Klebstoffsysteme zum einen aus einem Streifen aus Butylkautschuk-Kleber und zum anderen aus einem neoprenen, beidseitig mit Acrylatklebstoff beschichteten Schaumstoff. Butylkautschuk-Kleber hat eine hervorragende Klebkraft und Dichtwirkung, der ihn als solchen für eine vollflächige Verklebung zunächst als technisch besonders geeignet erscheinen lässt. Es hat sich aber gezeigt, dass Butylkautschuk-Kleber in längeren Zeiträumen zumindest an geneigten Flächen zum Fließen neigt. In der vorliegenden Zusammenstellung kann er jedoch hervorragend die Rolle eines Klebers mit sofortiger hoher Anfangsklebkraft übernehmen. Eine dauerhafte, ortsfeste Verbindung wird dann durch das zweite Klebstoffsystem unter Verwendung von Acrylatklebstoff gewährleistet. Acrylat-Kleber haben sich beispielsweise für die Befestigung von Kunststoffteilen in der Automobiltechnik hervorragend bewährt. Sie erreichen jedoch ihre volle Klebkraft erst nach einiger Zeit, sodass die Kombination mit dem Butyl-Klebesystem vorteilhaft ist. Da eine Folie aus Acrylat-Kleber an sich nicht geeignet ist, eine dauerelastische Verbindung zwischen dem Untergrund und dem Solar-Laminat herzustellen, wird erfindungsgemäß eine dünne Schicht aus neoprenem Schaumstoff verwendet, die beidseitig mit einer Acrylat-Klebefolie beschichtet ist. Neoprener Schaumstoff nimmt bekanntlich kein Wasser auf und ist langzeitig unverrottbar und dauerelastisch.

Vorteilhafterweise kann der neoprene Schaumstoff mit beiderseitiger Acrylat-Klebefolie rahmenförmig zugeschnitten werden; ein Mittelstreifen aus Butyl-Kautschuk wird nicht bis an das Ende des Laminates geführt, sodass er allseitig von dem Schaumstoff umgeben ist. Es entseht so eine vollflächige Verklebung ohne Fugen an den Rändern des Laminates, sodass ein Eindringen von Regenwasser unter das Laminat durch evtl. Fugen zwischen den Klebesystemen von vornherein ausgeschlossen ist.

Durch die Verwendung beider Systeme wird eine sofortige und dauerhaft stabile Verklebung der Solarmodule erreicht, die zudem den Vorteil hat, wegen ihrer dauerelastischen Eigenschaften eine Verwendung des selbstlebenden Moduls auch auf Dächern, die nicht aus Stahlblech bestehen, also an sich wegen ihres vom Laminat unterschiedlichen Ausdehnungskoeffizienten Probleme aufwerfen, zu gestatten.

Auf dem Markt befinden sich unter dem Handelsnamen "acrylic foam" Klebebänder von wenigen Millimetern Dicke mit ähnlich dauerelastischen Eigenschaften wie der beidseitig mit Acryl-Klebefolie beschichtete, neoprene Schaumstoff. Der Einsatz dieses Klebematerials verbietet sich jedoch, wenn vollflächig abdeckend gearbeitet werden soll, aus Preisgründen. Ein bis zwei schmale Streifen des "acrylic foam" können jedoch als drittes Klebesystem zusätzlich eingesetzt werden, um die Sicherheit der Verklebung noch weiter zu erhöhen.

Erfindungsgemäß sind in die Selbstklebeschicht flache elektrische Leitungen zum elektrischen Anschluss auf der Dach/Fassadenaußenseite eingebettet. Zur wahlweisen Serien- oder Parallel-Verschaltung von außen sind zusätzlich Leitungen für die Durchgangsverdrahtung in die Selbstklebeschicht eingebettet.

Die Leitungen bestehen aus je einem flachen, nicht zu dünnen Band aus Kupfer, das mit dem Anschlusspunkten des Laminates (plus und minus) verlötet und zwischen der Selbstklebeschicht und der Laminatrückseite zur Stirnseite des Laminates verlegt ist.

Für die Kupferbänder ist ein nicht zu geringer Querschnitt zu wählen (zum Beispiel 6 mm²), damit die Leitungsverluste auch bei den auftretenden, höheren Strömen (zum Beispiel 10 A) gering bleiben. Aus diesem Grund sind Kupferfolien, wie sie im Inneren eines jeden flexiblen Laminats Verwendung finden, ungeeignet. Es versteht sich, dass als Bandmaterial weiche Kupferlegierungen benutzt werden, damit die Flexibilität der Module nicht durch die Kupferbänder beeinträchtigt wird.

Zusätzlich zu den Anschlussleitungen sind zwei gleichartige Kupferbänder über die ganze Länge des Laminates zwischen Klebeschicht und Laminatrückseite eingelegt, sodass pro Stirnseite jeweils ein Anschluss und zwei Enden der Durchgangsverdrahtung nach dem Aufkleben des Moduls zugänglich sind. Stoßen nun zwei Laminate stirnseitig aneinander, so können diese Bandenden mit den in der Elektrotechnik üblichen, einfachen Mitteln, beispielsweise auch mittels einer Nietzange, verbunden werden. Dabei können Querverbinder eingelegt werden, sodass die mittlere Anschlussleitung mit einer der beidseitig parallel nebenliegenden Durchgangsleitung verbunden wird. Auf diese Weise ist es beliebig möglich, entweder eine Reihenschaltung oder eine Parallelschaltung der Laminate herzustellen. Dies ist für die Praxis der Modulinstallation von entscheidender Bedeutung, weil einerseits die Anzahl der Laminat-Module von den Abmaßen des Daches bestimmt wird, andererseits die Bauart des Netzeinspeise-Wechselrichters, an welche die Module letztlich angeschlossen werden, bestimmte Strom- und Spannungsvorgaben macht, d.h. eine ganz bestimmte Modulzahl in Reihe bzw. in Parallelschaltung erfordert.

Nach dem Verbinden der stirnseitigen Anschlüsse werden diese zweckmäßig durch eine übergestülpte, dosenförmige Abdeckung geschützt, wobei der Hohlraum ggf. zusätzlich mit einer Wasser undurchlässigen Vergussmasse verfüllt wird.

Am ober- oder unterseitigen Ende einer jeden Laminatreihe wird zur Stromableitung ein spezielles Anschlussteil notwendig, das einen Kabelanschluss an die Enden der Kupferbänder gestattet und die Durchführung des Kabels durch die Dachhaut vorsieht. Der Innenraum dieses Anschlussteils wird ebenfalls witterungsfest abgedichtet, ggf. durch Vergießen. Insgesamt wird durch die vorgeschlagene Anschlusstechnik sichergestellt, dass pro Dachschare die Dachhaut nur an einer Stelle durch eine Kabelableitung durchbrochen wird und dass zugleich die Laminate einer Reihe beliebig in Serie oder Parallel verschaltbar sind. Die Verbindungstechnik ist einfach genug, um auch von Handwerkern, die nicht dem Elektrohandwerk angehören, bewerkstelligt zu werden.

Die Aufgabe, eine unerwünschte Stromerzeugung zu verhindern, wird gelöst, indem sonnenseitig die fertigen, verklebten Dachelemente mit einer lichtundurchlässigen Schutzfolie, die später rückstandslos abgezogen werden kann, abgeklebt wird. Diese spezielle Schutzfolie erfüllt zugleich die üblichen Forderungen eines mechanischen Schutzes gegen Beschädigung der empfindlichen Solar-Laminate beim Transport und der Montage.

Die Erfindung soll nachstehend anhand eines Ausführungsbeispiels näher erläutert werden. In den zugehörigen Zeichnungen zeigen
- Fig. 1: ein erfindungsgemäßes Solar-Laminat in einer Schnittdarstellung und
- Fig. 2: das Solar-Laminat gemäß Fig. 1 in Draufsicht.

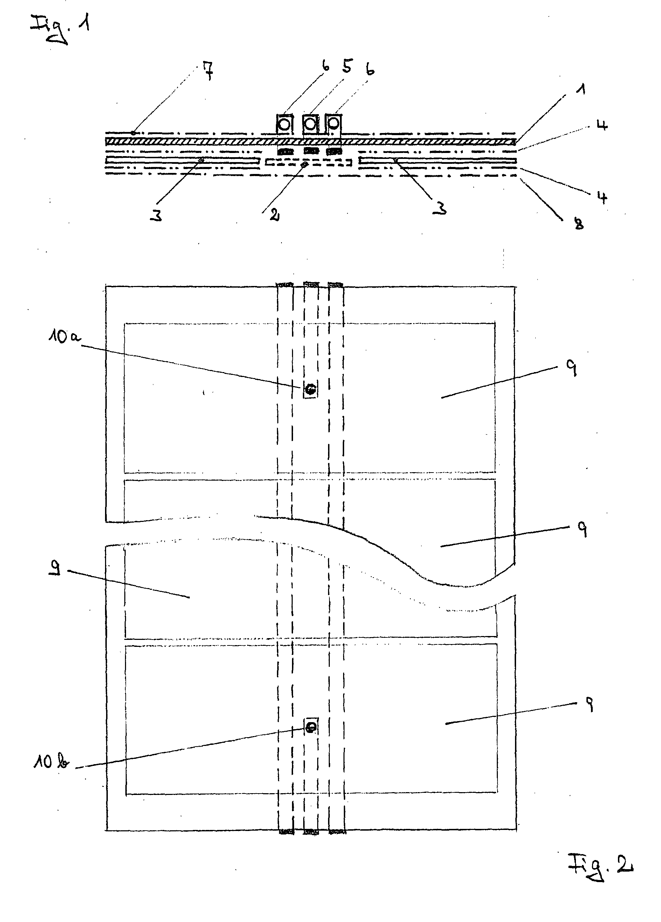

Auf die Unterseite einer industriell angebotenen lichtempfindlichen Solarfolie 1 wird, im vorliegenden Ausführungsbeispiel mittig, ein Streifen aus Butylkautschuk-Kleber 2 aufgebracht. Beiderseits des Butylkautschuk-Klebers 2 werden außerdem Streifen aus neoprenem Schaumstoff 3 aufgebracht, die beidseitig mit einer Acrylat-Klebefolie 4 beschichtet sind und die den Rest der Fläche der Solarfolie 1 bedecken.

Wie bereits oben erklärt, übernimmt der Butylkautschuk-Kleber 2 die Aufgabe einer Verklebung mit hoher Anfangsklebkraft, während die Acrylat-Klebefolie 4 die Aufgabe der Langzeitverklebung erfüllt.

Zur Handhabung der Laminate bis zum Aufbringen auf ein Dach oder ein Fassadenteil ist die so gebildete Selbstklebeschicht mit einer Abziehfolie 8, z. B. aus Wachspapier, abgedeckt.

Eingebettet in die Selbstklebeschicht sind Anschlussleitungen 5 und Durchgangsleitungen 6 aus Kupferband. Im vorliegenden Ausführungsbeispiel werden die Anschlussleitungen 5 und die Durchgangsleitungen 6 in ihrer Breite von dem Butylkautschuk-Kleber 2 bedeckt. Es hat sich als vorteilhaft erwiese, dass der Butylkautschuk-Kleber 2 als mittig angeordneter Streifen angebracht wird.

Die gezeigte Solarfolie 1 besteht aus drei Solarzellen 9, die untereinander fest verschaltet sind. Laminatweise sind ein Plus-Lötanschluss 10a und ein Minus-Lötanschluss 10b an den beiden Anschlussleitungen 5 vorgesehen. Zusätzlich sind Durchgangsleitungen 6 vorhanden, die von Laminat zu Laminat untereinander und an jeder Seite mit einer Anschlussleitung 5 (plus uns minus) verbunden werden können, so dass sich insgesamt eine Plus- und eine Minusschiene ergibt, an der die Laminate parallel angeschaltet sind. Für eine Reihenschaltung wird jeweils ein Plus-Lötanschluss 10a mit einem Minus-Lötanschluss 10b verbunden.

Damit mit den Laminaten gefahrlos hantiert werden kann, solange sie noch nicht verschaltet sind, wird die Oberfläche der Solarfolie 1 mit einer abziehbaren Lichtschutzfolie 7 versehen.

### Bezugszeichenliste

- 1: Solarfolie 1
- 2: Butylkautschuk-Kleber
- 3: Neoprener Schaumstoff
- 4: Acrylat-Klebefolie
- 5: Anschlussleitung
- 6: Durchgangsleitung
- 7: Lichtschutzfolie
- 8: Abziehfolie
- 9: Solarzelle
- 10: Plus-Lötanschluss
- 11: Minus-Lötanschluss

## Patentansprüche

1. Glasloses, flexibles Solar-Laminat zur Umwandlung von Tageslicht in elektrische Energie, hergestellt nach einer Dünnschicht-Technologie durch Abscheiden auf einem flexiblen Substrat,
**dadurch gekennzeichnet, dass**
es zur Vor-Ort-Befestigung auf ebenen Gebäude-Außenflächen wie Dach oder Fassade auf seiner Rückseite mit einer dauerelastischen Selbstklebeschicht versehen ist, in die flache elektrische Leitungen (5) zum elektrischen Anschluss auf der First- und Traufseite des Daches bzw. den Fassadenaußenseiten und zusätzlich Leitungen (6) für die Durchgangsverdrahtung eingebettet sind.

2. Solar-Laminat nach Anspruch 1,
**dadurch gekennzeichnet, dass**
die Selbstklebeschicht aus mindestens zwei, sich in ihrer Wirkweise hinsichtlich Anfangsklebkraft und Dauerklebkraft ergänzenden Klebstoffsystemen besteht.

3. Solar-Laminat nach Anspruch 2
**dadurch gekennzeichnet, dass**
die Klebstoffsysteme Butylkautschuk-Kleber (2) und neoprener, beidseitig mit Acrylatklebstoff beschichteter Schaumstoff (4) sind.

4. Solar-Laminat nach einem oder mehreren der vorhergehenden Ansprüche,
**dadurch gekennzeichnet, dass**
mindestens einer der Klebstoffe in Form einer Klebefolie vorliegt.

5. Solar-Laminat nach einem oder mehreren der vorhergehenden Ansprüche,
**dadurch gekennzeichnet, dass**
als ein drittes Klebstoffsystem acrylic-foam-Klebeband Bestandteil der Selbstklebeschicht ist.

6. Solar-Laminat nach einem oder mehreren der vorhergehenden Ansprüche,
**dadurch gekennzeichnet, dass**
die zusätzlichen Leitungen (6) für die Durchgangsverdrahtung von außen wahlweise in Serien- oder Parallel-Verschaltung mit den elektrischen Leitungen (5) zu verbinden sind.

7. Solar-Laminat nach einem oder mehreren der vorhergehenden Ansprüche,
**dadurch gekennzeichnet, dass**
seine lichtempfindliche Außenseite mit einer lichtundurchlässigen, nach der mechanischen und elektrischen Montage abziehbaren Schutzfolie (7) versehen ist.
